Europäisches Patentamt

European Patent Office

Office européen des brevets

(19)

(11) Veröffentlichungsnummer : **0 325 751 B1**

(12) **EUROPÄISCHE PATENTSCHRIFT**

(45) Veröffentlichungstag der Patentschrift :
**11.03.92 Patentblatt 92/11**

(51) Int. Cl.$^5$ : **H01L 39/24, B28B 11/00**

(21) Anmeldenummer : **88120743.5**

(22) Anmeldetag : **12.12.88**

(54) **Verfahren zur Herstellung eines langgestreckten elektrischen Leiters mit einem oxidkeramischen Supraleitermaterial und Vorrichtung zur Durchführung des Verfahrens.**

(30) Priorität : **23.12.87 DE 3743874**

(43) Veröffentlichungstag der Anmeldung :
**02.08.89 Patentblatt 89/31**

(45) Bekanntmachung des Hinweises auf die
Patenterteilung :
**11.03.92 Patentblatt 92/11**

(84) Benannte Vertragsstaaten :
**AT CH DE FR GB IT LI NL SE**

(56) Entgegenhaltungen :
**APPLIED PHYSICS LETTERS, Band 51, Nr. 21,
23. November 1987, Seiten 1753-1755, American Institute of Physics, New York, US; P.M.
MANKIEWICH et al.: "Reproducible technique
for fabrication of thin films of high transition
temperature superconductors"**

(73) Patentinhaber : **SIEMENS
AKTIENGESELLSCHAFT
Wittelsbacherplatz 2
W-8000 München 2 (DE)**

(72) Erfinder : **Ries, Günther, Dr.
Schobertweg 2
W-8520 Erlangen (DE)**

EP 0 325 751 B1

## Beschreibung

Die Erfindung bezieht sich auf ein Verfahren zur Herstellung eines langgestreckten elektrischen Leiters, der einen metallischen Körper enthält, welcher mit einem oxidkeramischen Supraleitermaterial eines metallische Komponente und Sauerstoff enthaltenden Stoffsystems mit hoher Sprungtemperatur versehen wird, bei welchem Verfahren der Leiter einer abschließenden Wärmebehandlung in einer sauerstoffhaltigen Atmosphäre unter Ausbildung einer tetragonalen Phase des Stoffsystems unterzogen wird und daran anschließend abgekühlt wird, wobei sich eine orthorhomische Phase des Stoffsystems ausbildet. Ein solches Verfahren ist z.B. in "Appl.Phys.Lett.", Vol. 51, No. 3, 20.7.1987, Seiten 203 und 204 angedeutet. Die Erfindung betrifft ferner eine Vorrichtung zur Durchführung dieses Verfahrens.

Supraleitende Metalloxidverbindungen wie z.B. auf Basis des Stoffsystems Me1-Me2-Cu-0 (Me1 = Seltene Erden einschließlich Yttrium; Me2 = Erdalkalimetalle) zeichnen sich durch hohe Sprungtemperaturen $T_c$ von insbesondere über 40 K aus. Aus diesen Materialien lassen sich z.B. Körper mit ausgeprägt drei-dimensionaler Gestalt, sogenanntes Bulk-Material, im allgemeinen auf pulvermetallurgischem Wege herstellen (vgl. z.B. "Z-.Phys. B -Condensed Matter", Band 66, 1987, Seiten 141 bis 146 oder "Phys.Rev.Lett.", Vol. 58, No.9, 2.3.1987, Seiten 908 bis 910). Neben der Ausbildung entsprechender Hoch-$T_c$-Supraleiter unter Verwendung von Bulk-Material ist auch die Herstellung von Schichten oder Filmen bekannt. Hierzu dienen vielfach spezielle PVD (Physical Vapor Deposition)-Prozesse wie z.B. Aufdampfen oder Aufsputtern. Dabei wird im allgemeinen auf einem geeigneten Substrat oder Trägerkörper ein Vorprodukt aus den Komponenten der gewünschten Zusammensetzung mit einem Gefüge abgeschieden, das hinsichtlich der auszubildenden supraleitenden Metalloxidphase noch fehlstrukturiert ist. Dieses Vorprodukt wird anschließend durch eine allgemein in einer sauerstoffhaltigen Atmosphäre durchzuführenden abschließenden Wärmebehandlung in das Material mit der gewünschten supraleitenden Phase überführt. Die hierbei vorzusehenden Glühtemperaturen liegen im allgemeinen sehr hoch, beispielsweise bei 900°C. Da die die supraleitenden Phasen aufweisenden Materialien einer Oxidkeramik ähnlich sind, werden die entsprechenden Hoch-$T_c$-Supraleiter auch als oxidkeramische Supraleiter bezeichnet.

Die so zu erhaltenden supraleitenden Hoch-$T_c$-Metalloxidphasen, die Strukturen auf Perowskit-Basis zeigen, haben im Falle von $(La-Me2)_2CuO_{4-y}$ (mit $y \gtrsim 0$) ein tetragonales $K_2NiF_4$-Gefüge (vgl. z.B. "Jap.Journ.Appl-.Phys.", Vol. 26, No. 2, Part 2 - Letters, Febr. 1987, Seiten L123 und L124). Demgegenüber wird im Falle von $YBa_2Cu_3O_{7-x}$ (mit $0 < x < 0,5$) eine orthorhombische Struktur angenommen (vgl. z.B. "Europhys.Lett.", Vol. 3, No. 12, 15.6.1987, Seiten 1301 bis 1307). Diese Struktur bildet sich jedoch bei der erforderlichen abschließenden Wärmebehandlung in einer sauerstoffhaltigen Atmosphäre zunächst nicht, sondern es entsteht auch hier eine tetragonale Phase. Erst bei der sich daran anschließenden Abkühlung in der sauerstoffhaltigen Atmosphäre erfolgt ein struktureller Phasenübergang von der tetragonalen zur orthorhombischen Phase, die Voraussetzung für die hohen Sprungtemperaturen des Materials ist.

Hohe kritische Stromdichten, wie sie mit Helium-Kühltechnik erforderlichen konventionellen Supraleitern zu erreichen sind, werden bisher nur in dünnen, etwa 1 μm dicken Schichten erzielt, die mittels Molekularstrahlepitaxie auf orientierten einkristallinen Substraten aus Strontiumtitanat aufgebracht werden (vgl. z.B. "Phys.Rev.Lett.", Vol. 58, No. 25, 22.6.1987, Seiten 2684 bis 2686). In den bisher hergestellten Einkernleitern, die z.B. durch Herunterziehen eines mit einem gepulverten Hoch-$T_c$-Supraleitermaterial gefällten Metallrohres aus beispielsweise Silber, Gold oder Platin hergestellt wurden (vgl. z.B. "Appl.Phys.Lett.", Vol. 51, No. 3, 20.7.1987, Seiten 203 und 204 oder "E-MRS-Meeting", Strasbourg, 3.6.1987, Beitrag C22 von J.Joshino et al. mit dem Titel: "Superconducting Wire and Coil with Zero Resistance at 90 K and Current Density of 510 A/cm² at 77 K"), ist die erzielte kritische Stromdichte jedoch noch sehr unbefriedigend.

Es wurde angedeutet, daß durch Drahtziehen im Warmzustand eine Struktur erzeugt werden kann, in der die c-Achse senkrecht zur Längsrichtung des Leiters steht (vgl. z.B. "Adv. Cer. Mat.", vol. 2, No. 3B, Special Issue July 1987, Seiten 388 bis 400)

Aufgabe der vorliegenden Erfindung ist es deshalb, das Verfahren gemäß der eingangs genannten Art dahingehend auszugestalten, daß mit ihm langgestreckte elektrische Leiter mit einem oxidkeramischen Supraleitermaterial zu erhalten sind, deren kritische Stromdichte gegenüber entsprechenden bekannten Leitern erhöht ist. Als Supraleitermaterial ist dabei ein Stoffsystem zu wählen, das den erwähnten strukturellen Phasenübergang von der tetragonalen zur orthorhombischen Phase zeigt.

Diese Aufgabe wird erfindungsgemäß dadurch gelöst, daß während des langsamen Abkühlens in der sauerstoffhaltigen Atmosphäre bei einer Temperatur des strukturellen Phasenübergangs von der tetragonalen zur orthorhombischen Phase der Leiter bleibend um 0,5 bis 1,5 % in Längsrichtung gedehnt wird.

Mit dieser Dehnungsbehandlung wird erreicht, daß in dem Hoch-$T_c$-Supraleitermaterial die sogenannten Zwillingsgrenzen, d.h. innere Oberflächen zwischen kristallinen Bereichen verschiedener Orientierung, zumindest großenteils beseitigt werden.

Diese Zwillingsgrenzen lassen sich gut in der supraleitenden orthorhombischen Phase nachweisen (vgl. z.B. "Z.Phys.B -Condensed Matter", Vol. 69, 1987, Seiten 21 bis 27) und entstehen, wenn sich beim Abkühlen von der hohen Bildungstemperatur von etwa 900°C bis 1000°C bei etwa 700°C bis 800°C die tetragonale Hochtemperaturphase in die orthorhombische Struktur umwandelt (vgl. z.B. "Phys.Rev.B", Vol. 36, No. 7, Sept. 1987, Seiten 3608 bis 3616).

Es besteht nun die Auffassung (vgl. z.B. "Phys.Rev.Lett", Vol. 59, No. 15, 12.10.1987, Seiten 1745 bis 1747), daß solche inneren Oberflächen sogenannte "weak links" zwischen den gut-supraleitenden Bereichen darstellen, welche den Stromdurchgang durch das Material so behindern, daß die Stromtragfähigkeit eines daraus gefertigten Leiters auf einen unakzeptabel niedrigen Wert von beispielsweise einigen 100 A/cm$^2$ gedrückt wird (vgl. z.B. "Appl.Phys.Lett.", Vol. 51, No. 12, 21.9.1987, Seiten 943 bis 945).

Bei der erwähnten Phasenumwandlung verzerrt sich das Kristallgitter, wobei die vormals quadratische Anordnung der Atome in der sogenannten Basalebene mit Gitterbasisvektoren a = b = 0,358 nm (vgl. z.B. "Phys.Rev.B", Vol. 36, 1987, Seiten 3608 ff) in eine rechteckige Anordnung mit b = (1,01 bis 1,02).a übergeht. Dabei kann in verschiedenen Bereichen eines ursprünglich einkristallinen Kornes die Zuordnung von a und b zu den Hauptachsen der Basalebene abwechseln, was an den Berührungsflächen notwendigerweise zur Bildung der erwähnten Zwillingsgrenzen führt (vgl. "Z.Phys.B -Condensed Matter", Vol. 69, 1987, Seiten 21 bis 27).

Erfindungsgemäß wird nun durch mechanische Dehnung um ein Verhältnis von etwa

$$\frac{b - a}{b + a}$$

bei der Phasenumwandlungstemperatur zumindest in den günstig orientierten Körnern das Wachstum der Zwillingsbereiche, bei denen die längere b-Achse etwa in Richtung der Dehnung zeigt, so bevorzugt, daß die energetisch ungünstigere Bildung von Bereichen mit b etwa senkrecht zur Dehnungsrichtung zumindest weitgehend unterbleibt. Damit bilden sich praktisch keine Zwillingsgrenzen innerhalb der Kristallkörner aus. Aus diesem Grunde zeigen nach dem erfindungsgemäßen Verfahren hergestellte langgestreckte Leiter vorteilhaft eine höhere kritische Stromdichte als entsprechende bekannte Leiter.

Vorteilhafte Ausgestaltungen des erfindungsgemäßen Verfahrens gehen aus den Unteransprüchen hervor.

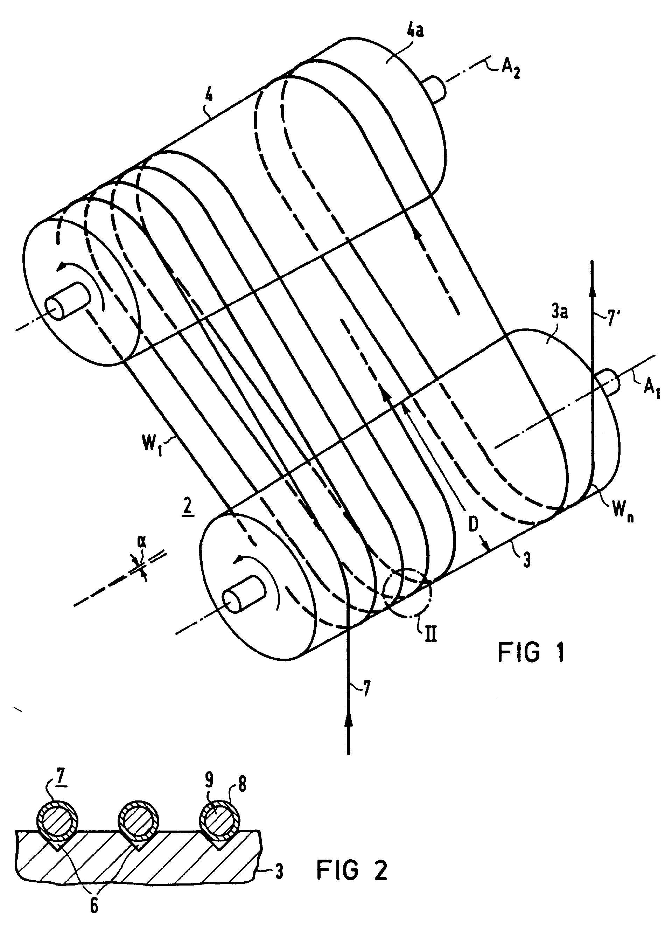

Zur weiteren Erläuterung der Erfindung wird nachfolgend auf die Zeichnung Bezug genommen, in deren Figur 1 schematisch eine Vorrichtung zur Durchführung des erfindungsgemäßen Verfahrens angedeutet ist. Figur 2 zeigt einen Ausschnitt aus dieser Vorrichtung.

Mit dem erfindungsgemäßen Verfahren lassen sich langgestreckte elektrische Leiter herstellen, die oxidkeramisches Supraleitermaterial mit hoher Sprungtemperatur $T_c$ enthalten, das einem Stoffsystem mit metallischen Komponenten und Sauerstoff zuzurechnen ist. Zur Erläuterung der Erfindung sei das vierkomponentige Me1-Me2-Cu-0 ausgewählt. Die Erfindung ist jedoch nicht nur auf dieses Stoffsystem beschränkt; d.h., es ist ebensogut auch für andere oxidkeramische, zumindest teilweise andere und/oder zusätzliche metallische Komponenten und Sauerstoff enthaltende Hoch-$T_c$-Supraleitermaterialien geeignet, die dem genannten Stoffsystem nicht zuzurechnen sind. Voraussetzung hierfür ist lediglich, daß der erwähnte strukturelle Phasenübergang auftritt.

Bei dem zur Erläuterung der Erfindung ausgewählten Stoffsystem der Zusammensetzung Me1-Me2-Cu-0 sind als Ausgangsmaterialien für das auszubildende Supraleitermaterial Me1 und Me2 aus der Gruppe der Seltenen Erdmetalle wie z.B. Y bzw. aus der Gruppe der Erdalkalimetalle wie z.B. Ba zu wählen. Neben Y für Me1 und Ba für Me2 geeignete Materialien sind allgemein bekannt. Dabei sollen die entsprechenden metallischen Komponenten des Stoffsystems Me1-Me2-Cu-0 jeweils mindestens ein (chemisches) Element aus den genannten Gruppen enthalten oder jeweils aus diesem mindestens einen Element bestehen. Me1 und Me2 können also vorzugsweise jeweils ein Element sein. Gegebenenfalls sind jedoch auch Legierungen oder Verbindungen oder sonstige Zusammensetzungen dieser Metalle mit Substitutionsmaterialien als Ausgangsstoffe geeignet; d.h., mindestens eines der genannten Elemente kann gegebenenfalls partiell durch ein anderes substituiert sein.

Das aus den Ausgangsmaterialien zu erstellende Supraleitermaterial soll dabei mit einem metallischen Körper verbunden sein. Bei diesem Körper kann es sich beispielsweise um ein Metallrohr handeln, das das supraleitende Material umhüllt (vgl. z.B. "Appl.Phys.Lett.", Vol. 51, No. 3, 20.7.87, Seiten 203 und 204). Hierzu wird in bekannter Weise ein pulverförmiges Vorprodukt in Form einer oder mehrerer Seelen in eine rohrförmige Metallhülle eingebracht. Bei der Metallhülle kann es sich beispielsweise um ein Ag-Rohr mit einem Durchmesser von einem bis mehreren cm handeln (vgl. z.B. den genannten Beitrag C22 des "E-MRS Meeting", Strasbourg 1987). Dieser Aufbau wird dann einem oder mehreren querschnittsvermindernden Schritten unterzogen, bis die gewünschten Abmessungen des Leiters von beispielsweise einem oder mehreren mm erhalten sind. Auch ein entsprechendes Hämmern oder Walzen ist möglich. Um die Stöchiometrie der gewünschten supraleitenden Hoch-$T_c$-Phase zu erhalten, ist eine abschließende Wärmebehandlung des querschnittsverminderten Aufbaus erforderlich, die in einer sauerstoffhaltigen Atmosphäre, d.h. entweder in Luft oder in reinem Sauerstoff, vorgenommen werden muß. Im Falle der Herstellung von $YBa_2Cu_3O_{7-x}$ sind hierbei Temperaturen zwischen 700°C und 1000°C, beispielsweise bei etwa 950°C, während 1 bis 10 Stunden erforderlich. Bei dieser Wärmebehandlung bildet sich jedoch nicht die gewünschte orthorhombische Hoch-$T_c$-Phase, sondern eine tetragonale Phase aus. Kühlt man danach den Leiter in einer sauerstoffhaltigen Atmosphäre langsam ab, so tritt ein struktureller Phasenübergang von der tetragonalen zu der orthorhombischen Phase auf. Unter einer langsamen Abkühlungsgeschwindigkeit seien hierbei zumindest im Temperaturbereich der Phasenumwandlung höchstens 100°C pro Stunde verstanden. Gemäß der Erfindung ist nun vorgesehen, daß bei der Temperatur dieses strukturellen Phasenüberganges der Leiter bleibend um 0,5 bis 1,5 % in seiner Längsrichtung gedehnt wird. Dies kann durch Ziehen an den Enden oder Walzen bzw. Führen durch einen Ziehstein mit dem Ziel einer entsprechenden, gleichgroßen Querschnittsverminderung geschehen. Das sich anschließende Abkühlen auf Raumtemperatur soll dann in einem Zeitraum von mindestens einer Stunde erfolgen.

Für eine Drahtherstellung läßt sich dieser Prozeßschritt insbesondere kontinuierlich mit einer Walzenanordnung durchführen, wie sie in Figur 1 schematisch in Schrägansicht veranschaulicht ist. Die allgemein mit 2 bezeichnete Walzenanordnung weist zwei Walzen 3 und 4 auf, die um parallelliegende Achsen $A_1$ bzw. $A_2$ mit gleichem Drehsinn rotieren. Beide Walzen sind leicht konisch ausgebildet; d.h., ihre Mantelflächen 3a bzw. 4a bilden jeweils mit der Achse $A_1$ bzw. $A_2$ einen spitzen Winkel $\alpha$. Dieser Winkel ist dabei so bemessen, daß die gewünschte Dehnung erreicht wird. So nimmt beispielsweise der Walzenum fang in Achsrichtung insgesamt um 1 bis 3 % zu. Wie aus dem in Figur 2 gezeigten Ausschnitt aus der Walze 3 hervorgeht, sind die Mantelflächen 3a und 4a mit Nuten oder Rillen 6 versehen. Diese Rillen sollen dabei gemäß Figur 1 derart verlaufen, daß ein mit ihrer Hilfe geführter drahtförmiger Supraleiter die beiden Walzen 3 und 4 spiralförmig mehrfach umschlingt. Der in eine erste Windung $W_1$ der Walzenanordnung 2 einlaufende Supraleiter ist dabei mit 7, der aus der Anordnung herausgeführte Leiter mit 7' bezeichnet. Der Leiter weist dabei eine rohrförmige Hülle 8 z.B. aus Ag auf, die einen Kern 9 aus dem Hoch-$T_c$-Supraleitermaterial wie insbesondere aus $YBa_2Cu_3O_{7-x}$ umgibt. Beim Durchlauf des drahtförmigen Supraleiters 7 durch die Walzenanordnung nimmt die Leitergeschwindigkeit entsprechend dem steigenden Walzendurchmesser D allmählich zu, bis bei der letzten Windung $W_n$ die angestrebte Gesamtdehnung in der Größenordnung von 0,5 bis 1,5 %, vorzugsweise von etwa 0,9 %, erreicht ist. Gleichzeitig mit diesem Dehnungsprozeß durchläuft der Supraleiter 7 den kritischen Temperaturbereich zwischen etwa 800°C und 600°C, in dem die tetragonal-orthorhombische Umwandlung stattfindet.

Beinicht gerillten Walzen kann der Supraleiter auch durch Führungsstifte bzw. -bleche zwischen den Walzen in der gewünschten spiralförmigen Bahn geführt werden.

Gemäß dem anhand der Figuren dargestellten Ausführungsbeispiel wurde davon ausgegangen, daß der Supraleiter 7 aus einem mit dem gepulverten Supraleitermaterial gefüllten Metallrohr aufgebaut ist. Ebensogut kann es sich bei dem der erfindungsgemäßen Dehnungsbehandlung zu unterziehenden Supraleiter auch um ein auf seiner Oberfläche mit dem Supraleitermaterial beschichtetes Band, Rohr oder sonstigen Körper handeln. Dabei kann der erfindungsgemäße Verfahrensschritt auch bei auf andere Weise hergestellten Leitern angewandt werden wie z.B.

— bei Bandleitern, auf die der Supraleiter durch Sputtern, chemische Abscheidung aus der Dampfphase (CVD), Abscheidung aus wäßriger Lösung mit nachfolgendem Tempern, als Suspension in einem organischen Binder, durch Aufschmelzen oder Oxidieren einer Legierung der metallischen Bestandteile aufgebracht wird;
— bei Filamentleitern mit einem drahtförmigen Träger, auf den eine entsprechende Supraleiterschicht nach einem der vorgenannten Verfahren aufgebracht wird.

Wesentlich ist hierbei lediglich, daß während eines langsamen Abkühlens in Luft oder Sauerstoff bei Annäherung an die Temperatur des strukturellen Phasenübergangs von der tetragonalen zur orthorhombischen Phase des Hoch-$T_c$-Supraleitermaterials bzw. im Bereich dieser Temperatur der gesamte Aufbau bleibend in der erwähnten Größenordnung in Längsrichtung des Leiters gedehnt wird. Hierzu können auch andere als in den Figuren 1 und 2 dargestellte Dehnungseinrichtungen vorgesehen werden.

Das erfindungsgemäße Verfahren gründet sich dabei auf folgenden Supraleitermechanismus in dem Hoch-$T_c$-Material:

— Die Leitungselektronen bewegen sich zweidimensional in den Kupfer-Sauerstoffebenen.
— Eine Singularität in der elektronischen Zustandsdichte spaltet in der orthorhombischen Phase in zwei Peaks um die Fermienergie auf.
— Zwischen den Elektronenzuständen in diesen Peaks gibt es zusätzliche Streuprozesse unter Austausch eines optischen Phonons. Dies erhöht den supraleitenden Kopplungsparameter und somit die Sprungtemperatur $T_c$ bis zu dem beobachteten Wert.
— Strukturelle Störungen wie z.B. Zellwände oder Gitterverzerrungen verkleinern und verwaschen diese Zustandsdichtepeaks in ihrer Umgebung, so daß $T_c$ dort reduziert wird. Der Supraleiter erscheint als Ansammlung gut supraleitender, aber miteinander nur schwach gekoppelter Körner und kann dadurch nur einen kleinen Transportstrom tragen.

– Nach Magnetisierungsmessungen sind diese gut leitenden Körner mit etwa 0,1 bis 1 μm kleiner als die Kristallite. Es ist davon auszugehen, daß die Zwillingsgrenzen zwischen Bereichen abwechselnder Orientierung der a- und b-Kristallachsen der orthorhombischen Phase solche Störungen darstellen. Sie begrenzen homogene Bereiche der beobachteten Größe der supraleitenden Körner.

– Mit den erfindungsgemäßen Maßnahmen wird nun bei der Bildungstemperatur der orthorhombischen Phase die lange b-Achse vorzugsweise entlang dem Leiter ausgerichtet, womit eine Bildung der Zwillingsgrenzen behindert wird. Die Folge davon ist eine entsprechende Erhöhung des maximalen Transportstromes. In einem Pulverkernleiter gemäß dem beschriebenen Ausführungsbeispiel kann so die kritische Stromdichte um mehr als eine Größenordnung erhöht werden.

## Patentansprüche

1. Verfahren zur Herstellung eines langgestreckten elektrischen Leiters, der einen metallischen Körper enthält, welcher mit einem oxidkeramischen Supraleitermaterial eines metallische Komponenten und Sauerstoff enthaltenden Stoffsystems mit hoher Sprungtemperatur versehen wird, bei welchem Verfahren der Leiter einer abschließenden Wärmebehandlung in einer sauerstoffhaltigen Atmosphäre unter Ausbildung einer tetragonalen Phase des Stoffsystems unterzogen wird und daran anschließend abgekühlt wird, wobei sich eine orthorhombische Phase des Stoffsystems ausbildet, **dadurch gekennzeichnet,** daß während des langsamen Abkühlens in der sauerstoffhaltigen Atmosphäre bei einer Temperatur des strukturellen Phasenübergangs von der tetragonalen zur orthorhombischen Phase der Leiter (7, 7′) bleibend um 0,5 bis 1,5 % in Längsrichtung gedehnt wird.

2. Verfahren nach Anspruch 1, **dadurch gekennzeichnet,** daß der Leiter (7, 7′) um etwa 0,9 % gedehnt wird.

3. Verfahren nach Anspruch 1 oder 2, **dadurch gekennzeichnet,** daß die Dehnungsbehandlung bei einer Temperatur zwischen 800°C und 600°C vorgenommen wird.

4. Verfahren nach einem der Ansprüche 1 bis 3, **dadurch gekennzeichnet,** daß nach der abschließenden Wärmebehandlung der Leiter (7, 7′) zumindest im Temperaturbereich des strukturellen Phasenübergangs mit einer Abkühlungsgeschwindigkeit von höchstens 100°C/Stunde abgekühlt wird.

5. Verfahren nach einem der Ansprüche 1 bis 4, **dadurch gekennzeichnet,** daß die Dehnungsbehandlung durch Ziehen oder Walzen des Leiters (7, 7′) vorgenommen wird.

6. Verfahren nach einem der Ansprüche 1 bis 5, **dadurch gekennzeichnet,** daß der Leiter (7′) nach der Dehnungsbehandlung bei der vorbestimmten Temperatur langsam über mindestens 1 Stunde auf Raumtemperatur abgekühlt wird.

7. Verfahren nach einem der Ansprüche 1 bis 6, **dadurch gekennzeichnet,** daß ein oxidkeramisches Supraleitermaterial auf Basis des Stoffsystems Me1-Me2-Cu-0 ausgebildet wird, wobei die metallischen Komponenten Me1 und Me2 ein Element aus der Gruppe der Seltenen Erdmetalle (einschließlich Yttrium) bzw. ein Element aus der Gruppe der Erdalkalimetalle zumindest enthalten.

8. Vorrichtung zur Durchführung des Verfahrens nach einem der Ansprüche 1 bis 7, **dadurch gekennzeichnet,** daß zur Dehnung des Leiters (7, 7′) zwei rotierende, achsenparallele Walzen (3, 4) mit leicht konischen Mantelflächen (3a, 4a) vorgesehen sind, über die der Leiter (7, 7′) in mehreren Windungen ($W_1$ bis $W_n$) spiralförmig zu führen ist.

9. Vorrichtung nach Anspruch 8, **dadurch gekennzeichnet,** daß die Walzen (3, 4) mit Nuten oder Rillen (6) in ihren Mantelflächen (31, 4a) zur Führung des Leiters (7, 7′) versehen sind.

## Claims

1. Process for the production of a longitudinally stretched electrical conductor which comprises a metallic body which is provided with an oxide ceramic superconductor material of a material system with a high transition temperature containing metallic components and oxygen, in which process the conductor is subjected to a final heat treatment in an oxgyen-containing atmosphere with the development of a tetragonal phase of the material system, and is then cooled, with an orthorhombic phase of the material system being formed, characterised in that during the slow cooling in the oxygen-containing atmosphere, at a temperature of the structural phase transition from the tetragonal to the orthorhombic phase, the conductor (7, 7′) is permanently stretched in the longitudinal direction by 0.5 to 1.5%.

2. Process according to claim 1, characterised in that the conductor (7, 7′) is stretched by approximately 0.98.

3. Process according to claim 1 or 2, characterised in that the stretching treatment is carried out at a temperature between 800°C and 600°C.

4. Process according to one of claims 1 to 3, characterised in that after the final heat treatment the conductor (7, 7′) is cooled, at least in the temperature range of the structural phase transition, with a cooling rate of at the most 100°C/hour.

5. Process according to one of claims 1 to 4, characterised in that the stretching treatment is effected by drawing or rolling the conductor (7, 7′).

6. Process according to one of claims 1 to 5, characterised in that after the stretching treatment at the predetermined temperature the conductor (7′) is slowly cooled over at least one hour to room temperature.

7. Process according to one of claims 1 to 6, characterised in that an oxide ceramic superconductor material based on the material system Me1-Me2-Cu-0 is formed, with the metallic components Me1 and Me2 containing at least an element from the group of rare earth metals (including yttrium) and an element from the group of alkaline earth metals respectively.

8. Device for carrying out the process according to one of claims 1 to 7, characterised in that in order to stretch the conductor (7, 7′) two rotating axially parallel rollers (3, 4) with slightly conical outer surfaces (3a, 4a) are provided, over which the conductor (7,7′) is to be guided spirally in several windings ($W_1$ to $W_n$).

9. Device according to claim 8, characterised in that the rollers (3, 4) are provided with grooves or channels (6) in their outer surfaces (3a, 4a) for guiding the conductor (7, 7′).


**Revendications**

1. Procédé pour fabriquer un conducteur électrique allongé qui comporte un corps métallique d'un matériau supraconducteur oxycéramique qui est pourvu d'un système de substances à haute température de transition comportant des composants métalliques et de l'oxygène, procédé dans lequel le conducteur est soumis à un traitement thermique final dans une atmosphère à teneur en oxygène, avec formation d'une phase tétragonale du système de substances, pour ensuite être refroidi, une phase orthorhombique du système de substance se formant, caractérisé par le fait que pendant le refroidissement lent dans l'atmosphère à teneur en oxygène et à une température du passage de phase structural de la phase tétragonale à la phase orthorhombique, le conducteur (7, 7′) est allongé de façon permanente de 0,5 à 1, 5 % suivant la direction longitudinale.

2. Procédé selon la revendication 1, caractérisé par le fait que le conducteur (7, 7′) est allongé d'environ 0,9 %.

3. Procédé selon la revendication 1 ou 2, caractérisé par le fait que le traitement d'allongement est opéré à une température se situant entre 800° C et 600° C.

4. Procédé selon l'une des revendications 1 à 3, caractérisé par le fait qu'après le traitement thermique final, le conducteur (7, 7′) est refroidi dans une plage de température du passage de phase structural, avec une vitesse de refroidissement au plus égale à 100° C/heure.

5. Procédé selon l'une des revendications 1 à 4, caractérisé par le fait que le traitement d'allongement est opéré par traction ou par laminage du conducteur (7, 7′).

6. Procédé selon l'une des revendications 1 à 5, caractérisé par le fait que le conducteur (7, 7′) est, après le traitement d'allongement, opéré à la température prédéterminée, refroidi lentement et pendant au moins une heure, à la température ambiante.

7. Procédé selon l'une des revendications 1 à 6, caractérisé par le fait que l'on forme un matériau oxycéramique à supraconductjon, sur la base du système de substances Me1 - Me2 - Cu - 0, les constituants métalliques Me1 et Me2 contenant au moins un élément du groupe des métaux de terres rares (y compris l'Yttrium)ou un élément du groupe des métaux alcalino-terreux.

8. Dispositif pour la mise en oeuvre du procédé selon l'une des revendications 1 à 7, caractérisé par le fait qu'il est prévu, pour allongement du conducteur (7, 7′), deux cylindres tournants (3, 4) à axes parallèles présentant des surfaces-enveloppes légèrement coniques (3a, 4a) et sur lesquelles le conducteur (7, 7′) est guidé suivant un agencement hélicoïdal avec plusieurs spires ($W_1$ à $W_n$).

9. Dispositif selon la revendication 8, caractérisé par le fait que les cylindres (3, 4) sont pourvus de gorges ou de sillons (6), ménagés dans leurs surfaces-enveloppes (3a, 4a) et servant au guidage du conducteur (7, 7′).

EP 0 325 751 B1

FIG 1

FIG 2

7